(19) Europäisches Patentamt
European Patent Office
Office européen des brevets

(11) Veröffentlichungsnummer: **0 332 881**
**A1**

(12) ## EUROPÄISCHE PATENTANMELDUNG

(21) Anmeldenummer: **89102837.5**

(51) Int. Cl.⁴: **G01R 19/175 , G01R 21/133**

(22) Anmeldetag: **18.02.89**

(30) Priorität: **16.03.88 CH 991/88**

(43) Veröffentlichungstag der Anmeldung:
**20.09.89 Patentblatt 89/38**

(84) Benannte Vertragsstaaten:
**AT CH DE ES FR GB IT LI**

(71) Anmelder: **ASEA BROWN BOVERI AG**
**Haselstrasse**
**CH-5401 Baden(CH)**

(72) Erfinder: **Roth, Arthur**
**Langäckerstrasse 51**
**CH-8957 Spreitenbach(CH)**

(54) **Verfahren zur digitalen Messwerterfassung und digitales Messgerät.**

(57) Für die Regelung von Drehfeldmaschinen (15) bei elektrischen Antrieben und in der Energieversorgung sind elektrische Messgrössen für den Blindstrom, Wirkstrom, die Blindleistung, Wirkleistung und den Leistungsfaktor erforderlich. Bei Fernübertragungen und in grösseren Systemen wird vorzugsweise mit digitalen Grössen gearbeitet. Um den Aufwand bei der Umwandlung analoger elektrischer Messgrössen in digitale zu vermindern, werden die Spannungsnulldurchgänge der verketteten und unverketteten Wechselspannungen detektiert (7) und zum Zeitpunkt des Spannungsnulldurchganges ($S_O$) die entsprechenden Phasenstrom-Istwerte erfasst und in einem Abtast- und Halteglied (6) gespeichert. Aus dem Null-Durchgang einer Phasenspannung resultiert ein entsprechender Blindstromwert. Aus dem Null-Durchgang einer verketteten Wechselspannung resultieren ein Wirkstromwert und ein Amplitudenwert einer Phasenspannung, welche in einem Abtast- und Halteglied (6') gespeichert wird. Diese gespeicherten Strom- und Spannungswerte werden über eine Kanalanwahleinrichtung (8) nacheinander einem Analog-Digital-Umsetzer (9) zugeführt und in einem Schieberegister (10) während 60 °el zwischengespeichert. Die Auswertung der digitalisierten Messgrössen erfolgt anschliessend mittels eines Mikro-rechners (11), der u.a. über einen Digital-Analog-Umsetzer (12), einen Zündsignalgenerator (13) und einen Regelstromrichter (14) die Drehfeldmaschine (15) regelt.

FIG.1

EP 0 332 881 A1

## VERFAHREN ZUR DIGITALEN MESSWERTERFASSUNG UND DIGITALES MESSGERÄT

### TECHNISCHES GEBIET

Bei der Erfindung wird ausgegangen von einem Verfahren zur digitalen Messwerterfassung mindestens einer Wechselspannung und/oder mindestens eines Wechselstromes an mindestens einer eine Wechselspannung führenden Leitung und von einem digitalen Messgerät zur Durchführung des Verfahrens nach den Oberbegriffen der Patentansprüche 1 und 6.

### STAND DER TECHNIK

Mit den Oberbegriffen nimmt die Erfindung auf einen Stand der Technik Bezug, wie er aus der deutschen Zeitschrift: Regelungstechnische Praxis, 24 (1982)6, S. 197 - 202 bekannt ist. Dort ist eine Universalmesseinheit beschrieben, die unter Verwendung eines Mikrorechners aus 16 Abtastwerten in 10 ms je Phase der Ströme $i_{(v)}$ und Spannungen $u_{(v)}$ eines Drehstromsystems digital die zugehörigen Effektivwerte $I^2_{(v)}$, $U^2_{(v)}$ sowie Blindleistung $Q_{(v)}$, Wirkleistung $P_{(v)}$, Scheinleistung $S_{(v)}$ und Leistungsfaktor cos $\phi$ berechnet. Der von den Messgrössenaufnehmern gelieferte Messwert wird für jeden Kanal über einen digital einstellbaren Verstärker, einen nachgeschalteten Tiefpass mit einer Grenzfrequenz gleich der halben Abtastfrequenz und über ein Abtast- und Halteglied einem Analog-Multiplexer zugeführt, von wo die Messwerte nacheinander über einen Analog-Digital-Umsetzer zu einem Mikrorechner zur Auswertung gelangen. Der Rechner übernimmt alle notwendigen Steuerfunktionen, die Umschaltung der Verstärkung, die Ein- und Ausgabe, die Reaktion auf externe Signale usw. Aus den Abtastwerten der Ströme und Spannungen werden die quadratischen Effektivwerte sowie Wirk-und Blindleistung nach dem Verfahren der fortlaufenden Mittelwertbildung bestimmt, wobei der Mittelwert nach jeder Abtastung für eine feste Anzahl zurückliegender Abtastwerte errechnet wird. Diese Auswertung ist relativ aufwendig.

### DARSTELLUNG DER ERFINDUNG

Die Erfindung, wie sie in den Patentansprüchen 1 und 6 definiert ist, löst die Aufgabe, den Aufwand bei der Umsetzung analoger elektrischer Messgrössen in digitale zu vermindern.

Ein Vorteil der Erfindung besteht darin, dass die Kosten für die Umsetzung verringert werden können. Gleichzeitig wird eine hohe Zuverlässigkeit der Umsetzung gewährleistet. Insbesondere eignen sich das erfindungsgemässe Verfahren und das digitale Messgerät bei Messungen an Generatoren für die öffentliche Energieversorgung, bei denen Ströme und Spannungen unter normalen Bedingungen annähernd sinusförmig und die Belastung einigermassen symmetrisch sind.

### KURZE BESCHREIBUNG DER ZEICHNUNGEN

Die Erfindung wird nachstehend anhand eines Ausführungsbeispiels erläutert. Es zeigen:

Fig. 1 ein Blockschaltbild einer Regeleinrichtung einer Drehfeldmaschine mit einem digitalen Messgerät,

Fig. 2 ein Blockschaltbild einer Spannungsnulldurchgangs-Erfassungseinrichtung des digitalen Messgerätes gemäss Fig. 1,

Fig. 3 ein Struktogramm der Kanalanwahleinrichtung des digitalen Messgerätes gemäss Fig. 1,

Fig. 4 ein Zeitdiagramm von Phasenströmen sowie verketteten und unverketteten Phasenspannungen eines Drehstromnetzes gemäss Fig. 1,

Fig. 5 ein Signaldiagramm von Spannungsnulldurchgangssignalen der verketteten und unverketteten Phasenspannungen gemäss den Fig. 2 und 4,

Fig. 6 ein Signaldiagramm von Synchronisiersignalen der Spannungsnulldurchgangs-Erfassungseinrichtung gemäss den Fig. 2 und 4,

Fig. 7 einen Ausschnitt aus dem Zeitdiagramm von Fig. 4 zur Erläuterung der Blindstrommessung und

Fig. 8 einen Ausschnitt aus dem Zeitdiagramm von Fig. 4 zur Erläuterung der Wirkstrommessung.

## WEGE ZUR AUSFÜHRUNG DER ERFINDUNG

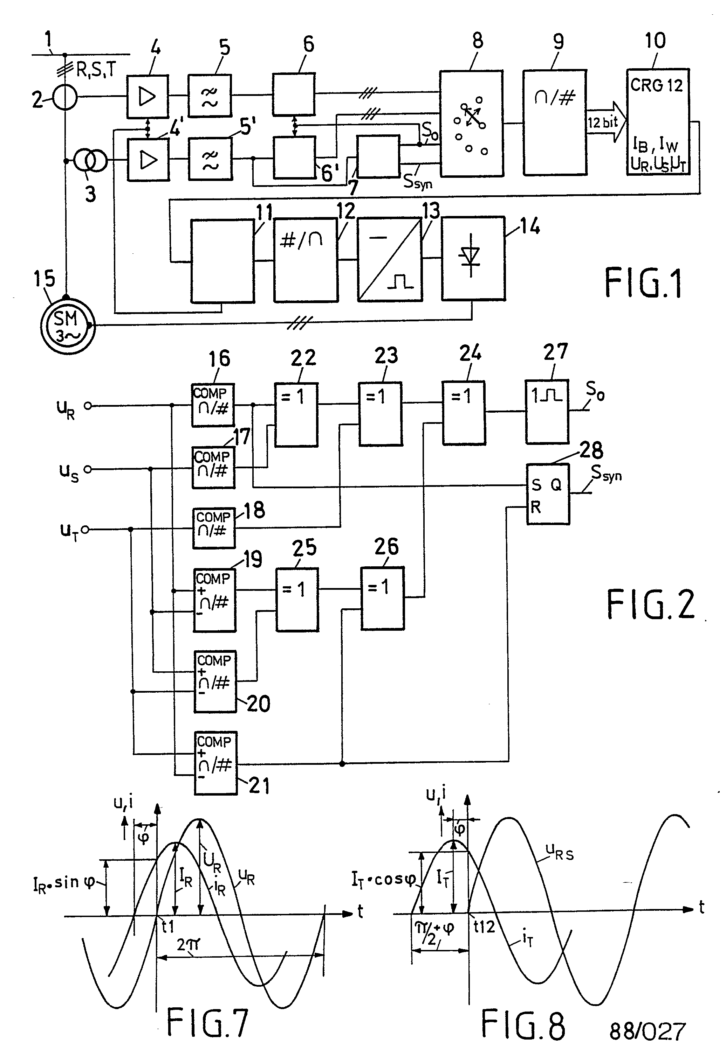

In Fig. 1 ist mit 1 ein 3phasiges Drehstromnetz mit den Phasen R, S, T bezeichnet, das über einen Stromdetektor bzw. Stromwandler 2 je Drehstromphase mit den Statorwicklungen einer Drehfeldmaschine bzw. Synchronmaschine 15 verbunden ist. Der Stromwandler 2 ist über einen digital einstellbaren Verstärker 4, ein nachgeschaltetes Tiefpassfilter 5 und ein Abtast- und Halteglied 6 (Sample & Hold) mit einem Analog-Multiplexer bzw. einer Kanalanwahleinrichtung 8 verbunden.

Das Drehstromnetz 1 steht ferner mit der Kanalanwahleinrichtung 8 über einen Spannungswandler 3 je Phase, über einen digital einstellbaren Verstärker 4', ein nachgeschaltetes Tiefpassfilter 5' und ein Abtast- und Halteglied 6' in Verbindung. Der Ausgang des Tiefpassfilters 5' steht ferner über eine näher in Fig. 2 dargestellte Spannungsnulldurchgangs-Erfassungseinrichtung 7 mit der Kanalanwahleinrichtung 8 in Verbindung, der sie ein Spannungsnulldurchgangssignal $S_O$ und ein Synchronisiersignal $S_{syn}$ liefert. Das Spannungsnulldurchgangssignal $S_O$ steuert die beiden Abtast- und Halteglieder 6 und 6'.

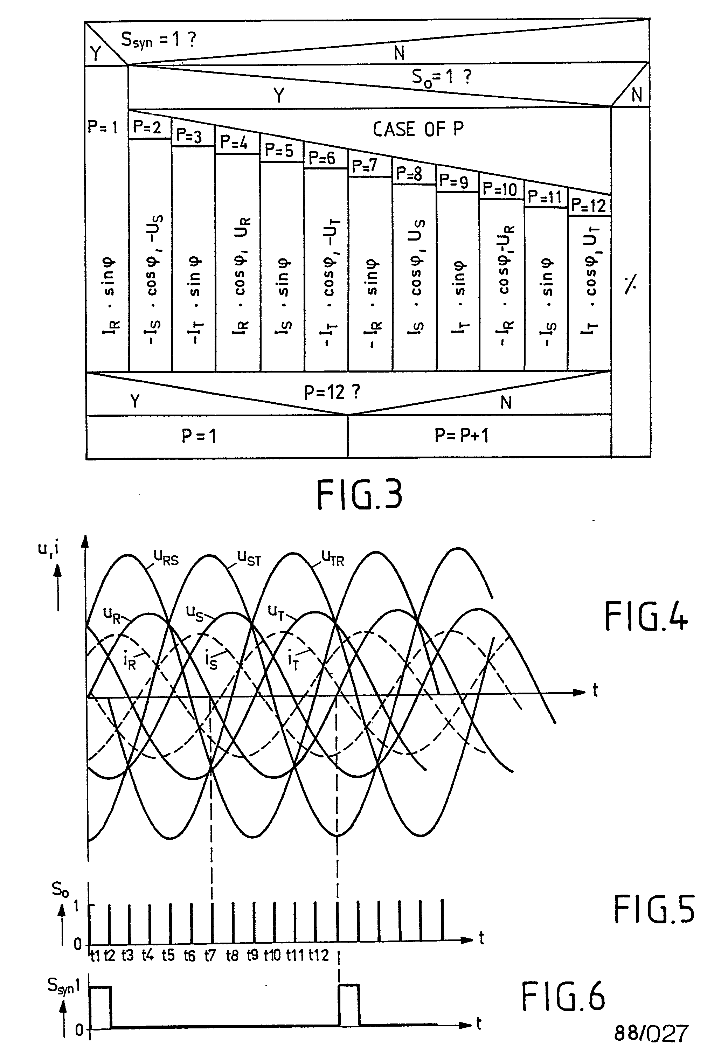

Die Kanalanwahleinrichtung 8 steuert in Abhängigkeit von den Signalen $S_O$ und $S_{syn}$ gemäss dem Struktogramm von Fig. 3 die eingangsseitig anliegenden Strom- und Spannungswerte nacheinander an einen eingangsseitig angeschlossenen Analog-Digital-Umsetzer 9. Dieser Analog-Digital-Umsetzer 9 liefert die digitalisierten Messdaten über einen Schreib-Lese-Zwischenspeicher bzw. ein Schieberegister 10 mit 12 bit alle 60 °el an einen Mikrorechner 11 zur Auswertung. Der Mikrorechner 11 steuert getrennt (nicht dargestellt) die Verstärkungsfaktoren der Verstärker 4 und 4' und berechnet die Zündsignale, die über einen Digital-Analog-Umsetzer 12 und einen nachgeschalteten Zündisgnalgenerator 13 einen Erregerstromrichter 14 steuern, der ausgangsseitig mit den Rotorwicklungen der Synchronmaschine 15 verbunden ist.

Das in Fig. 2 dargestellte Blockschaltbild zeigt die Spannungsnulldurchgangs-Erfassungseinrichtung 7 von Fig. 1. Spannungsnulldurchgangskomparatoren 16 - 18 sind eingangsseitig mit Phasenleitern mit den Wechsel- bzw. Phasenspannungen $U_R$ bzw. $u_S$ bzw. $U_T$ verbunden; sie liefern ausgangsseitig nur dann ein 1-Signal, wenn die jeweilige Wechselspannung durch Null geht, andernfalls liefern sie ein O-Signal.

An Spannungsnulldurchgangskomparatoren 19 - 21 sind eingangsseitig verkettete Wechselspannungen bzw. die Spannungen $U_{RS} = u_R - u_S$ bzw. $u_{ST} = u_S - u_T$ bzw. $u_{TR} = u_T - u_R$ angelegt. Ausgangsseitig liefern sie nur dann ein 1-Signal, wenn die jeweilige verkettete Wechselspannung durch Null geht. Mit 22 - 26 sind Antivalenz- bzw. Exklusiv-ODER-Elemente bezeichnet, die in einer Kaskadenschaltung die Ausgänge der Spannungsnulldurchgangskomparatoren 16 - 21 mit einem nicht nachtriggerbaren, monostabilen Kippgliedes 27 mit vorgebbarer Triggerzeit verbinden, an dem ausgangsseitig das Spannungsnulldurchgangssignal $S_O$ vorgebbarer Dauer abgreifbar ist, vgl. Fig. 5.

Der Ausgangs des Spannungsnulldurchgangskomparators 16 ist ferner ausgangsseitig mit dem Setzeingang S und der Ausgang des Spannungsnulldurchgangskomparators 21 ist mit dem Rücksetzeingang R eines RS-Flipflops 28 verbunden, an dem ausgangsseitig das Synchronisiersignal $S_{syn}$ abgreifbar ist, vgl. Fig. 6. Das Setzen des RS-Flipflops 28 erfolgt durch den Null-Durchgang der Phasenspannung $u_R$ in einem Zeitpunkt t1, vgl. Fig. 5, das Rücksetzen durch den Null-Durchgang der verketteten Spannung $u_{TR}$ in einem späteren Zeitpunkt t2.

In den Fig. 4, 7 und 8 sind auf der Ordinate der Wechselstrom i und die Wechsespannung u in willkürlichen Einheiten und auf der Abszisse die Zeit t aufgetragen.

Fig. 7 zeigt als Detail aus Fig. 4 die Messung des Blindstromes $I_{BR} = i_R = I_R \cdot \sin\phi$ im Zeitpunkt t1 des Null-Durchganges der Phasenspannung $u_R$, welche dem Phasenstrom $i_R$ um den Phasenwinkel $\phi$ voreilt. $U_R$ bezeichnet die Amplitude der Phasenspanung $u_R$ und $I_R$ die Amplitude des Phasenstromes $i_R$. Im Zeitpunkt t1 wird, ausgelöst durch das Spannungsnulldurchgangssignals $S_O$, das Stromsignal $i_R$ vom Abtast- und Halteglied 6 über die Kanalanwahleinrichtung 8 und den Analog-Digital-Umsetzer 9 in das Schieberegister 10 gebracht und dort zwischengespeichert. Bei einstellbarer Skalierung im Verstärker 4 liegt somit im Schieberegister 10 sofort der gewünschte, richtige Blindstromwert vor.

Fig. 8 zeigt als Detail aus Fig. 4 die Messung des Wirkstromes $I_{WT} = i_T = I_T \cdot \cos\phi$ im Zeitpunkt t12 des NUll-Durchganges der verketteten Wechselspannung $U_{RS}$, welche dem Phasenstrom $i_T$ um den Phasenwinkel $\Pi/2 + \phi$ voreilt. $I_T$ bezeichnet die Amplitude des Phasenstromes $i_T$. Im Zeitpunkt t12 wird das Stromsignal $i_T$ vom Abtast- und Halteglied 6 über die Kanalanwahleinrichtung 8 und den Analog-Digital-Umsetzer 9 in das Schieberegister 10 gebracht und als gewünschter, richtiger Wirkstromwert zwischengespeichert. Das Synchronisiersignal $S_{syn}$ wiederholt sich nach jeder Periode von $2\Pi$ der Phasenspannung $u_R$; es dient zur Zählung der 12 Nulldurchgangssignale $S_O$ je Periode und zur Einstellung der Kanalanwahleinrichtung 8, wie es nachfolgend anhand der Fig. 3 und 4 erläutert werden soll.

Im Zeitpunkt t1 sind infolge des Spannungsnulldurchgangs von $u_R$ die Signale $S_{syn}$ = 1 und $S_O$ = 1. Ein Zähler P im Struktogramm von Fig. 3 erhält den Wert 1 zugewiesen. Die Kanalanwahleinrichtung 8 schaltet den Wert $i_R$ = $I_R$ $\cdot$ $\sin\phi$ durch. Danach wird P um den Wert 1 erhöht auf den Wert P = 2.

Im Zeitpunkt t2 wird infolge des Spannungsnulldurchgangs von $u_{TR}$ $S_{syn}$ = O und $S_O$ = 1. Die Kanalanwahleinrichtung 8 schaltet den Wert $i_S$ = -$I_S$ $\cdot$ $\cos\phi$ durch. Sobald der Analog-Digital-Umsetzer 9 diesen Wert digitalisiert hat, d.h. nach ca. 20 $\mu$s schaltet die Kanalanwahleinrichtung 8 den Wert $u_S$ = -$U_S$ auf den Analog-Digital-Umsetzer 9. Danach wird P um 1 auf P = 3 erhöht.

Entsprechend werden in den nachfolgenden Zeitpunkten t3 - t12 infolge von Spannungsnulldurchgängen von: $u_T$, $u_{ST}$, $u_S$, $u_{RS}$, $u_R$, $u_{TR}$, $u_T$, $u_{ST}$, $u_S$ und $u_{RS}$ nacheinander die Messwerte: $i_T$ = -$I_T$ $\cdot$ $\sin\phi$; $i_R$ = $I_R$ $\cdot$ $\cos\phi$ und $u_R$ = $U_R$; $i_S$ = $I_S$ $\cdot$ $\sin\phi$; $i_T$ = -$I_T$ $\cdot$ $\cos\phi$ und $u_T$ = -$U_T$; $i_R$ = -$I_R$ $\cdot$ $\sin\phi$; $i_S$ = $I_S$ $\cdot$ $\cos\phi$ und $u_S$ = $U_S$; $i_T$ = $I_T$ $\cdot$ $\sin\phi$; $i_R$ = -$I_R$ $\cdot$ $\cos\phi$ und $u_R$ = -$U_R$; $i_S$ = -$I_S$ $\cdot$ $\sin\phi$ sowie $i_T$ = $I_T$ $\cdot$ $\cos\phi$ und $u_T$ = $U_T$ über die Kanalanwahleinrichtung 8 an den Analog-Digital-Umsetzer 9 zugeführt. I und U sind jeweils die Amplituden der zeitabhängigen physikalischen Grössen i und u bezeichnet. Nach dem Zeitpunkt t12 kann ein neuer 12er Zyklus beginnen.

Statt 2er Abtast- und Halteglieder 6 und 6$'$ genügt z.B. ein Abtast-Halteglied 6$'$ für die Speicherung der Spannungsamplituden $\pm U_R$, $\pm U_S$, $\pm U_T$, die mit kurzer zeitlicher Verzögerung nach den 6 Wirkstromwerten, vgl. Fig. 3, übertragen werden. Es könnten aber auch diese Spannungsamplituden gleichzeitig mit dem Auftreten des Spannungsnulldurchgangssignals $S_O$ übertragen werden und anschliessend die im Abtast- und Halteglied 6 gespeicherten entsprechenden Wirkstromwerte, wobei sich das Abtast- und Halteglied 6$'$ erübrigt.

Mit dem Mikrorechner 11 können durch entsprechende Programmierung aufgrund der detektierten physikalischen Grössen:

| | |
|---|---|
| Blindstrom | $I_{B\nu}$ = $I_\nu$ $\cdot$ $\sin\phi$, |
| Wirkstrom | $I_{W\nu}$ = $I_\nu$ $\cdot$ $\cos\phi$ und |
| Spannungsamplitude | $U_\nu$ |

u.a. folgende physikalische Grössen berechnet und für Regelsowie Begrenzungsfunktionen weiterverwendet werden:

| | |
|---|---|
| Blindleistung | $Q_\nu$ = $U_\nu$ $\cdot$ $I_\nu$ $\cdot$ $\sin\phi$, |
| Wirkleistung | $P_\nu$ = $U_\nu$ $\cdot$ $I_\nu$ $\cdot$ $\cos\phi$ und |
| Leistungsfaktor | $\cos\phi$ = cos (arc tan Q/P), |

$\nu$ = R, S, T. Die Auswertung erfolgt alle 60 $\overset{\bullet}{}$el mit Mittelwertbildung.

Es versteht sich, dass der Ausgang des Rechners mit einem nicht dargestellten Drucker und/oder Bildschirmgerät und/oder mit einer Signaleinrichtung verbunden sein kann, über welche diese Mess- bzw. Rechengrössen ausgegeben bzw. dargestellt werden können.

Anstelle des monostabilen Kippgliedes 27 in Fig. 2 könnte auch ein RS-Kippglied verwendet werden, das in Abhängigkeit von einem Ausgangssignal des Analog-Digital-Umsetzers 9 nach erfolgter Digitalisierung zurückgesetzt wird.

## Ansprüche

1. Verfahren zur ditigalen Messwerterfassung mindestens einer Wechselspannung und/oder mindestens eines Wechselstromes an mindestens einer eine Wechselspannung führenden Leitung (1)
 a) wobei die Wechselspannung einem Wechselspannungskomparator zugeführt wird und
 b) der Wechselstrom mittels eines Stromdetektors (2) erfasst wird,
 dadurch gekennzeichnet,
 c) dass der Spannungsnulldurchgang der Wechselspannung ($u_R$ , $u_S$, $u_T$) detektiert und der Stromistwert ($i_R$, $i_S$, $i_T$) zum Zeitpunkt des Spannungsnulldurchganges erfasst wird.

2. Verfahren nach Anspruch 1 für ein 3phasiges Wechselspannungssystem (R, S, T), dadurch gekennzeichnet, dass für mindestens eine Wechselstromphase ($i_R$) der Spannungsnulldurchgang der zugehörigen verketteten Phasenspannung ($u_{ST}$) der beiden zyklisch folgenden Phasenspannung detektiert wird.

3. Verfahren nach Anspruch 2, dadurch gekennzeichnet, dass zum Zeitpunkt aller Spannungsnulldurchgänge der Phasenspannungen ($u_R$, $u_S$, $u_T$) und der verketteten Phasenspannungen ($u_{RS}$, $u_{ST}$, $u_{TR}$) die zugehörigen Stromistwerte ($i_R$, $i_S$, $i_T$) erfasst, digitalisiert und zwischengespeichert werden.

4. Verfahren nach einem der Ansprüche 1 bis 3, dadurch gekennzeichnet, dass zum Zeitpunkt mindestens eines Spannungsnulldurchganges einer verketteten Phasenspannung ($u_{RS}$, $u_{ST}$, $u_{TR}$) die Amplitude der zugehörigen nichtverketteten Phasenspannung ($U_R$, $U_S$, $U_T$) erfasst, digitalisiert und zwischengespeichert wird.

5. Verfahren nach einem der Ansprüche 3 oder 4, dadurch gekennzeichnet, dass die Zwischenspeicherung während mindestens 1/6 der Periode des Wechselstromes erfolgt.

6. Digitales Messgerät zur Erfassung mindestens einer Wechselspannung und/oder mindestens eines Wechselstromes an mindestens einer eine Wechselspannung führenden Leitung (1), zur Durchführung des Verfahrens nach einem der Ansprüche 1 bis 5,

a) wobei eine Kanalanwahleinrichtung (8) vorgesehen ist,

b) die eingangsseitig mit Messgrössenaufnehmern (2, 3) und

c) ausgangsseitig über einen Analog-Digital-Umsetzer (9) mit einem Mikrorechner (11) in Wirkverbindung steht,

dadurch gekennzeichnet,

d) dass für mindestens eine Phasenspannung ein Spannungsnulldurchgangskomparator (16 - 18) vorgesehen ist, der eingangsseitig mit der spannungführenden Leitung (1) und ausgangsseitig mit der Kanalanwahleinrichtung (8) in Wirkverbindung steht.

7. Digitales Messgerät nach Anspruch 6 für ein 3phasiges Wechselspannungssystem (R, S, T), dadurch gekennzeichnet, dass für mindestens eine verkettete Wechselspannung ($u_{RS}$, $u_{ST}$, $u_{TR}$) ein Spannungsnulldurchgangskomparator (19 - 21) vorgesehen ist, der eingangsseitig mit zugehörigen Phasenleitern und ausgangsseitig mit der Kanalanwahleinrichtung (8) in Wirkverbindung steht.

8. Digitales Messgerät nach Anspruch 7, dadurch gekennzeichnet, dass für jede Phasenspannung ($u_R$, $u_S$, $u_T$) und für jede verkettete Wechselspannung ($u_{RS}$, $u_{ST}$, $u_{TR}$) ein Spannungsnulldurchgangskomparator (16 - 21) vorgesehen ist und dass die Spannungsnulldurchgangskomparatoren ausgangsseitig über mindestens ein Kippglied (27, 28) mit der Kanalanwahleinrichtung (8) in Wirkverbindung stehen.

9. Digitales Messgerät nach einem der Ansprüche 6 bis 8, dadurch gekennzeichnet,

a) dass die Kanalanwahleinrichtung (8) 1. - 3. Phasenspannungsnulldurchgängen ($u_R$, $u_S$, $u_T$) 1. - 3. Phasenblindströme ($i_{BR}$, $i_{BS}$, $i_{BT}$) und

b) 1. - 3. verketteten Wechselspannungsnulldurchgängen ($u_{RS}$, $u_{ST}$, $u_{TR}$) 1. - 3. Phasen-Wirkströme ($i_{WT}$, $i_{WR}$, $i_{WS}$) zuordnet.

10. Digitales Messgerät nach Anspruch 9, dadurch gekennzeichnet, dass die Kanalanwahleinrichtung (8) zusätzlich 1. - 3. verketteten Wechselspannungsnulldurchgängen ($u_{RS}$, $u_{ST}$, $u_{TR}$) 3. - 1. Phasenspannungsamplituden ($U_T$, $U_R$, $U_S$) zuordnet.

EP 0 332 881 A1

FIG.1

FIG.2

FIG.7

FIG.8

88/027

| | | | | | | | | | | | |
|---|---|---|---|---|---|---|---|---|---|---|---|
| $S_{syn} = 1$ ? | | | | | | | | | | | |
| Y | N | | | | | | | | | | |

$S_o = 1$ ?

| | | |
|---|---|---|
| Y | | N |

CASE OF P

| P= 1 | P=2 | P=3 | P=4 | P=5 | P=6 | P=7 | P=8 | P=9 | P=10 | P=11 | P=12 | |
|---|---|---|---|---|---|---|---|---|---|---|---|---|
| $I_R \cdot \sin\varphi$ | $-I_S \cdot \cos\varphi, -U_S$ | $-I_T \cdot \sin\varphi$ | $I_R \cdot \cos\varphi, U_R$ | $I_S \cdot \sin\varphi$ | $-I_T \cdot \cos\varphi, -U_T$ | $-I_R \cdot \sin\varphi$ | $I_S \cdot \cos\varphi, U_S$ | $I_T \cdot \sin\varphi$ | $-I_R \cdot \cos\varphi, -U_R$ | $-I_S \cdot \sin\varphi$ | $I_T \cdot \cos\varphi, U_T$ | % |

$P = 12$ ?

| Y | N |
|---|---|
| P = 1 | P = P+1 |

## FIG.3

FIG.4

FIG.5

FIG.6

88/027

# EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 257 004 (WESTINGHOUSE) * Figur 1; Spalte 14, Anspruch 18 * | 1,3 | G 01 R 19/175 G 01 R 21/133 |
| Y | | 8 | |
| Y | EP-A-0 243 835 (REINHAUSEN) * Zusammenfassung * | 8 | |
| A | US-A-4 024 459 (WILCOX) * Zusammenfassung * | 1-10 | |
| A | GB-A-2 100 941 (PHILIPS) * Seite 5, Zeilen 12-38 * | 1-10 | |

RECHERCHIERTE SACHGEBIETE (Int. Cl.4)

G 01 R

Der vorliegende Recherchenbericht wurde für alle Patentansprüche erstellt

| Recherchenort | Abschlußdatum der Recherche | Prüfer |
|---|---|---|
| DEN HAAG | 13-04-1989 | HOORNAERT W. |